# EUROPEAN PATENT SPECIFICATION

(11) **EP 3 887 563 B1**
(45) Date of publication and mention of the grant of the patent: **06.03.2024**
(21) Application number: 19828376.4
(22) Date of filing: 27.11.2019
(51) Int. Cl.: C23C 16/02, C23C 16/24, C23C 16/56, C23C 28/00, B23K 35/02

(54) **FLUID CONTACT PROCESS, COATED ARTICLE, AND COATING PROCESS**
FLUIDKONTAKTVERFAHREN, BESCHICHTETER GEGENSTAND UND BESCHICHTUNGSVERFAHREN
PROCÉDÉ DE CONTACT FLUIDIQUE, ARTICLE REVÊTU ET PROCÉDÉ DE REVÊTEMENT

(30) Priority: 29.11.2018 US 201862772747 P
(43) Date of publication of application: 06.10.2021
(73) Proprietor: Silcotek Corp., Bellefonte, Pennsylvania 16823 (US)
(72) Inventor: YUAN, Min, State College, Pennsylvania 16803 (US)
(74) Representative: Wallin, Nicholas James
(86) International application number: PCT/US2019/063513
(87) International publication number: WO 2020/112938

(56) References cited:
- US-A1- 2007 067 984
- US-A1- 2012 251 797
- US-A1- 2018 163 308

## Description

### FIELD OF THE INVENTION

The present invention is directed to coated articles, use of such coated articles, and processes of coating articles. More particularly, the present invention is directed to coatings containing carbon and silicon.

### BACKGROUND OF THE INVENTION

Coating aluminum-containing substrates with amorphous silicon in thermally-driven processes causes additional considerations in comparison to stainless steel. Such substrates are known to catalyze the crystallization of the amorphous silicon, as explained in Thin Solid Films 2017, 636, 150-157 by P. Bellanger, et al., and Phys. Status Solidi C 2017, 14 (10), 1700173 by P. Bellanger, et al.

The catalyzed crystallization of amorphous silicon coatings on aluminum-containing substrates is responsible for cosmetic inconsistencies considered to be undesirable and low corrosion-resistance properties in comparison to coated stainless steel substrates. The temperature-induced microstructural changes, such as metal sensitization, can worsen with the increase of temperature and exposure time.

Such aluminum-containing substrates coated with amorphous silicon in thermally-driven processes are also susceptible to microstructural changes at relatively low temperatures, resulting in incompatibilities with certain processes and/or undesirable properties. For example, microstructural changes occur at a relatively low temperature for aluminum Alloy 6061, which has, by weight, 0.9% Mg, 0.71% Si, 0.5% Fe, 0.24% Cu, 0.19% Cr, 0.12% Mn, 0.05% Zn, 0.05% Ti, and a balance Al ("Alloy 6061"). Alloy 6061 begins to have microstructural changes when exposed to temperatures greater than 225 degrees Celsius. According to "ANNEALING BEHAVIOR OF 6061 AL ALLOY SUBJECTED TO DIFFERENTIAL SPEED ROLLING DEFORMATION," Metals 2017, 7, 494, by Ko, Y. G. and Hamad, K, such changes continue to increase in effect at temperatures up to 350 degrees Celsius. At temperatures between 350 and 400 degrees Celsius, the microstructural changes are relatively consistent, independent of further increase.

Coating Alloy 6061 with amorphous silicon deposition processes above 225 degrees Celsius and especially processes operating at or above 350 degrees Celsius, therefore, have previously been considered undesirable due to the crystallization of the amorphous silicon and the microstructural changes in the substrate. Such undesirable features include, but are not limited to, sensitization of the substrate, catalyzing crystallization of silicon deposited on the substrate, cosmetic imperfections on the substrate or coated surfaces, and reduced corrosion-resistance properties.

One such type of process is thermal chemical vapor deposition at a temperature above 350 degrees Celsius. Thermal chemical vapor deposition processes operating above 350 degrees Celsius are disclosed in United States Patent No. 6,511,760, entitled "METHOD OF PASSIVATING A GAS VESSEL OR COMPONENT OF A GAS TRANSFER SYSTEM USING A SILICON OVERLAY COATING," United States Patent No. 6,444,326, entitled "SURFACE MODIFICATION OF SOLID SUPPORTS THROUGH THE THERMAL DECOMPOSITION AND FUNCTIONALIZATION OF SILANES," and United States Patent No. 9,777,368, entitled "CHEMICAL VAPOR DEPOSITION COATING, ARTICLE, AND METHOD,". Each of the processes of thermal chemical vapor deposition processes shows undesirable properties when used in conjunction with Alloy 6061. US 2018/163308 A1 discloses fluoro-containing thermal chemical vapor deposition processes and fluoro-containing thermal chemical vapor deposition treated articles.

An article having an aluminum-containing substrate, a process of coating an aluminum-containing substrate, and a fluid contact process using the article that show one or more improvements in comparison to the prior art would be desirable in the art.

### BRIEF DESCRIPTION OF THE INVENTION

In one aspect of the invention, a fluid contact process is described according to claim 3.

In a second aspect of the invention, a coated article is described according to claim 1.

In embodiment further aspect of the invention, a coating process is described according to claim 12.

A coated article, a fluid contact process and a coating process according to the invention are defined in the appended claims.

Other features and advantages of the present invention will be apparent from the following more detailed description, taken in conjunction with the accompanying drawings which illustrate, by way of example, the principles of the invention.

### BRIEF DESCRIPTION OF THE DRAWINGS

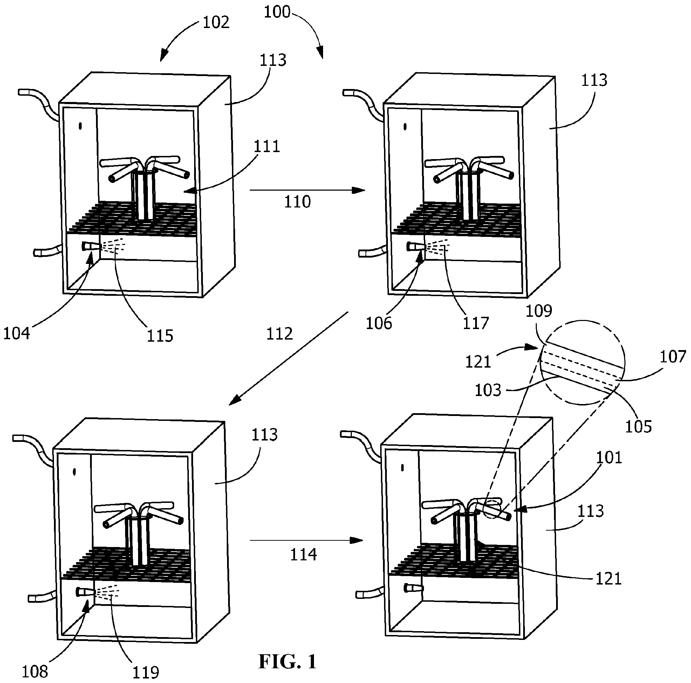

FIG. 1 is a schematic perspective view of a thermal chemical vapor deposition process, according to an embodiment of the disclosure.

Wherever possible, the same reference nu0mbers will be used throughout the drawings to represent the same parts.

### DETAILED DESCRIPTION OF THE INVENTION

Provided are fluid contact processes, coated articles, and coating processes. Embodiments of the present disclosure, for example, in comparison to concepts failing to include one or more of the features disclosed herein, increase consistency/repeatability of treatment, reduce or eliminate effects of residual materials thermally processed, increase inertness (for example, by reduction or elimination of atomic or molecular adsorption and/or by reduction or elimination of metal ion migration), increase resistance to sulfur adsorption, homogenize aesthetics, modify microstructure, reduce or eliminate delamination (or increase adhesion), reduce or eliminate growth of nanowires, modify optical properties, modify porosity, modify corrosion resistance, modify gloss, modify surface features, permit more efficient production of treatments, permit treatment of a wide range of geometries (for example, narrow channels/tubes, three-dimensionally complex geometries, tortuous paths, and/or hidden or non-line-of-site geometries, such as, in needles, tubes, probes, fixtures, complex planar and/or non-planar geometry articles, simple non-planar and/or planar geometry articles, and combinations thereof), reduce or eliminate defects/microporosity, permit treatment of a bulk of articles, are capable or being used in or replacing components that are used in industries traditionally believed to be too sensitive for processes that are not flow-through processes (for example, based upon compositional purity, presence of contaminants, thickness uniformity, and/or amount of gas phase nucleation embedded within), allow materials to be used as a substrate that would otherwise produce an electrical arc in a plasma environment, or permit a combination thereof.

Referring to FIG. 1, in one embodiment, a coated article 101 is disclosed. According to a further embodiment, the coated article 101 is produced according to an embodiment of a coating process 100. Additionally or alternatively, in one embodiment, the coated article 101 is used in conditions previously believed to be unsuitable for coated articles 101 including the features disclosed here. For example, embodiments of the using of the coated article 101 include flowing a corrosive fluid to contact the coated article 101. Such corrosive fluids include, but are not limited to, liquids and/or gases containing or being HCl, NaCl (vapor), H₂SO₄, phosphoric acid, toxic organics, sulfur-containing fluids, nitrogen-containing fluids, phosphorus-containing fluids, or a combination thereof.

According to one embodiment, the concentration of the corrosive fluid, such as, HCl is, by weight, between 1% and 10%, between 1% and 5%, between 2% and 4%, between 2% and 7%, between 2.5% and 5%, between 4% and 6%, or any suitable combination, sub-combination, or range therein.

According to one embodiment, the concentration of the corrosive fluid, such as, NaCl (vapor) is, by weight, between 1% and 10%, between 1% and 5%, between 2% and 4%, between 2% and 7%, between 4% and 6%, or any suitable combination, sub-combination, or range therein.

According to one embodiment, the concentration of the corrosive fluid, such as, H₂SO₄ is, by volume, between 5% and 85%, between 5% and 20%, between 20% and 40%, between 40% and 60%, between 60% and 85%, or any suitable combination, sub-combination, or range therein.

According to one embodiment, the concentration of the corrosive fluid, such as, phosphoric acid is, by volume, between 10% and 85%, between 10% and 20%, between 20% and 40%, between 40% and 60%, between 60% and 85%, or any suitable combination, sub-combination, or range therein.

Referring again to FIG. 1, the coated article 101 includes a substrate 103 and a thermal chemical vapor deposition coating 121 positioned on the substrate 103. Suitable components capable of being produced into the coated article 101 include, but are not limited to, gas storage vessels (for example, an article having an open end, a closed end, and a cylindrical portion between, an article having an open end and a spherical and/or round portion, such as, a gas cylinder or an air can), fittings (for example, unions, connectors, adaptors, other connections between two or more pieces of tubing, for example, capable of making a leak-free or substantially leak-free seal), compression fittings (including ferrules, such as, a front and back ferrule), tubing (for example, coiled tubing, tubing sections such as used to connect a sampling apparatus, pre-bent tubing, straight tubing, loose wound tubing, tightly bound tubing, and/or flexible tubing, whether consisting of the interior being treated or including the interior and the exterior being treated), valves (such as, gas sampling, liquid sampling, transfer, shut-off, or check valves, for example, including a rupture disc, stem, poppet, rotor, multi-position configuration, able to handle vacuum or pressure, a handle or stem for a knob, ball-stem features, ball valve features, check valve features, springs, multiple bodies, seals, needle valve features, packing washers, and/or stems), quick-connects, sample cylinders, regulators and/or flow-controllers (for example, including o-rings, seals, and/or diaphragms), injection ports (for example, for gas chromatographs), in-line filters (for example, having springs, sintered metal filters, mesh screens, and/or weldments), frits, columns, materials, glass liners, gas chromatograph components, liquid chromatography components, components associated with vacuum systems and chambers, components associated with analytical systems, sample probes, control probes, downhole sampling containers, drilled and/or machined block components, manifolds, particles, powders, or a combination thereof.

The coating 121 includes a first region (for example, on a substrate), such as, a silicon-and-carbon-containing layer 105 and a second region, such as, an amorphous-silicon-containing layer 107. The substrate is capable of being or including a single material, such as, an alloy. Additionally or alternatively, the substrate is capable of being or including weld(s), braze(s), a solder(s), dissimilar materials (for example, alloys having a mismatched coefficient of thermal expansion), or a combination thereof. In one embodiment, the silicon-and-carbon-containing layer 105 and the amorphous-silicon-layer 107 are separated by a region having oxygen at a greater concentration, by weight, than the silicon-and-carbon-containing layer 105. In one embodiment, one or more additional layers 109 are included. The additional layer(s) 109 are amorphous-silicon-containing.

The chemical vapor deposition process 100 includes positioning an uncoated article 111 (or a plurality of the uncoated articles 111) having the substrate 103 within an enclosed chamber 113. In one embodiment, the positioning is manually with the uncoated articles 111 being arranged generally horizontally ("generally" being within a 1 degree, 5 degrees, 10 degrees, or 15 degrees) or otherwise inconsistent with the direction of gravity. In another embodiment, the positioning is manually with the uncoated articles 111 being arranged in a vertical (stacked) orientation separated by supports (and thus obstructed from line-of-sight), arranged laterally or perpendicular to gravity (for example, with all or most openings being generally perpendicular to gravity, "generally" being within a 1 degree, 5 degrees, 10 degrees, or 15 degrees), arranged in an overlapping manner that reduces the amount of volume available for gas phase nucleation, positioned in a fixture corresponding with the geometry of the articles, or a combination thereof.

The process 100 continues with a first introducing (step 104) of a first fluid 115 (gas or liquid), for example, a dimethylsilane-and-silane-containing mixture, to the enclosed chamber 113. The first fluid 115 remains within the enclosed chamber 113 for a first period of time. The process continues with a first decomposing (step 110) of the first fluid 115 during at least a portion of the first period of time, and is repeated, if necessary. The process 100 then includes a second introducing (step 106) of a second fluid 117, for example, silane or silane diluted with inert gas, to the enclosed chamber 113, the second fluid 117 remaining within the enclosed chamber 113 for a second period of time. The process 100 continues with a second decomposing (step 112) of the second fluid 117 during at least a portion of the second period of time. In some embodiments, the process 100 further includes an additional introducing (step 108) of a third fluid 119 or a repeating of the second fluid 117 (for example, the silane, another fluid, and/or a functionalizing precursor, such as, a carbon-containing precursor and/or a fluoro-containing precursor). In such embodiments, the process 100 continues with a thermal processing (step 114), which is a decomposing or a functionalizing. The process 100 produces the coated article 101 (or a plurality of the coated articles 101).

The coating 121 is produced on all exposed surfaces. As used herein, the term "exposed," with regard to "exposed surfaces," refers to any surface that is in contact with gas during the process, and is not limited to line-of-sight surfaces or surfaces proximal to line-of-sight directions as are seen in flow-through chemical vapor deposition processes that do not have an enclosed vessel. As will be appreciated by those skilled in the art, the coated article 101 is capable of being incorporated into a larger component or system (not shown).

The coating 121 is produced, for example, thereby providing features and properties unique to being produced through the process 100, according to the disclosure, which is a static process using the enclosed vessel contrasted to flowable chemical vapor deposition that has concurrent flow of a precursor into and out of a chamber. As used herein, the phrase "thermal chemical vapor deposition" refers to a reaction and/or decomposition of one or more gases, for example, in a starved reactor configuration, and is distinguishable from plasma-assisted chemical vapor deposition, radical-initiated chemical vapor deposition, catalyst-assisted chemical vapor deposition, sputtering, atomic layer deposition (which is limited to a monolayer molecular deposition per cycle in contrast being capable of more than one layer of molecular deposition), and/or epitaxial growth (for example, growth at greater than 700°C). In one embodiment, the coating 121 is on the coated article 101 on regions that are unable to be coated through line-of-sight techniques.

The enclosed vessel 113 has any dimensions or geometry that allows suitable temperature and the pressures. In one embodiment, the dimensions for the enclosed vessel include, but are not limited to, having a minimum width of greater than 5 cm, greater than 10 cm, greater than 20 cm, greater than 30 cm, greater than 100 cm, greater than 300 cm, greater than 1,000 cm, between 10 cm and 100 cm, between 100 cm and 300 cm, between 100 cm and 1,000 cm, between 300 cm and 1,000 cm, any other minimum width capable of uniform or substantially uniform heating, or any suitable combination, sub-combination, range, or sub-range therein. Suitable volumes for the enclosed vessel include, but are not limited to, at least 1,000 cm³, greater than 3,000 cm³, greater than 5,000 cm³, greater than 10,000 cm³, greater than 20,000 cm³, between 3,000 cm³ and 5,000 cm³, between 5,000 cm³ and 10,000 cm³, between 5,000 cm³ and 20,000 cm³, between 10,000 cm³ and 20,000 cm³, any other volumes capable of uniform or substantially uniform heating, or any suitable combination, sub-combination, range, or sub-range therein.

The coating 121 is formed by one or more of the following fluids: silane, silane and ethylene, silane and an oxidizer, dimethylsilane, dimethylsilane and an oxidizer, trimethylsilane, trimethylsilane and an oxidizer, dialkylsilyl dihydride, alkylsilyl trihydride, non-pyrophoric species (for example, dialkylsilyl dihydride and/or alkylsilyl trihydride), thermally-reacted material (for example, carbosilane and/or carboxysilane, such as, amorphous carbosilane and/or amorphous carboxysilane), species capable of a recombination of carbosilyl (disilyl or trisilyl fragments), methyltrimethoxysilane, methyltriethoxysilane, dimethyldimethoxysilane, dimethyldiethoxysilane, trimethylmethoxysilane, trimethylethoxysilane, ammonia, hydrazine, trisilylamine, Bis(tertiary-butylamino)silane, 1,2-bis(dimethylamino)tetramethyldisilane, dichlorosilane, hexachlorodisilane), organofluorotrialkoxysilane, organofluorosilylhydride, organofluoro silyl, fluorinated alkoxysilane, fluoroalkylsilane, fluorosilane, tridecafluoro 1,1,2,2-tetrahydrooctylsilane, (tridecafluoro-1,1,2,2-tetrahydrooctyl) triethoxysilane, triethoxy (3,3,4,4,5,5,6,6,7,7,8,8,8-tridecafluoro-1-octyl) silane, (perfluorohexylethyl) triethoxysilane, silane (3,3,4,4,5,5,6,6,7,7,8,8,9,9,10,10,10-heptadecafluorodecyl) trimethoxy-, or a combination thereof.

Suitable concentrations of thermally-reactive gas used in the process 100, by volume, are between 10% and 20%, between 10% and 15%, between 12% and 14%, between 10% and 100%, between 30% and 70%, between 50% and 80%, between 70% and 100%, between 80% and 90%, between 84% and 86%, or any suitable combination, sub-combination, range, or sub-range therein. The concentrations of multiple types of the thermally-reactive gases are combined at ratios achieving the desired properties.

In one embodiment, the first fluid 115 includes a mixture of dimethylsilane and silane at a molar ratio of between 1:1 and 10:1, for example, based upon dimethylsilane pressure being at about 200 Torr, 240 Torr, 350 Torr, or less than 400 Torr. In a further embodiment, the molar ratio is based upon the amount of the dimethylsilane present, the reaction temperature within the enclosed vessel 113, and the reaction duration. For example, in one embodiment, the molar ratio is higher than 4:1, when more dimethylsilane is present, a higher reaction temperature is used, and/or the reaction time is longer. Likewise, in one embodiment, the molar ratio is lower than 1:1, when less dimethylsilane is present, a lower reaction temperature is used, and/or the reaction time is shorter.

In one embodiment, the molar ratio of dimethylsilane and silane is between 1:1 and 10:1, for example, between 7:1 and 9:1, between 2:1 and 4:1, or any suitable combination, sub-combination, range, or sub-range therein. In a further embodiment, the ratio is dependent upon the size of the enclosed vessel 113. For example, in an embodiment with the enclosed vessel 113 being about one-liter in volume, the ratio is within the range of between 2:1 and 4:1. In another embodiment with the enclosed vessel 113 being larger about 22 liters in volume, the ratio is between 7:1 and 9:1. In even further embodiments with the enclose vessel 113 being greater or smaller in volume, the ratio is adjusted accordingly.

Suitable thicknesses of the coating 121 include, but are not limited to, between 50 nanometers and 10,000 nanometers, between 50 nanometers and 1,000 nanometers, between 100 nanometers and 800 nanometers, between 200 nanometers and 600 nanometers, between 200 nanometers and 10,000 nanometers, between 500 nanometers and 3,000 nanometers, between 500 nanometers and 2,000 nanometers, between 500 nanometers and 1,000 nanometers, between 1,000 nanometers and 2,000 nanometers, between 1,000 nanometers and 1,500 nanometers, between 1,500 nanometers and 2,000 nanometers, 800 nanometers, 1,200 nanometers, 1,600 nanometers, 1,900 nanometers, or any suitable combination, sub-combination, range, or sub-range therein. More particularly, in one embodiment, the thickness of the coating 121 is between 50 nm and 900 nm, between 100 m and 800 nm, between 200 nm and 400 nm, between 300 nm and 600 nm, 50 nm, 100 nm, 150 nm, 200 nm, 250 nm, 300 nm, 350 nm, 400 nm, 450 nm, 500 nm, 550 nm, 600 nm, 650 nm, 700 nm, 750 nm, 800 nm, 850 nm, 900 nm, or any suitable combination, sub-combination, range, or sub-range therein.

In one embodiment, the coating 121 is produced with the process 100, specifically the introducing of the first fluid 115 (step 104), beginning with the enclosed vessel 113 being at a temperature below the decomposition temperature of the first fluid 115. The temperature within the enclosed vessel 113 is increased to above the decomposition temperature (for example, prior to introducing of a portion of the first fluid 115, during introducing of a portion or all of the first fluid 115, and/or after introducing of a portion or all of the first fluid 115). In a further embodiment, the decomposition temperature of the first fluid 115 or a portion of the first fluid 115 is greater than 200°C, greater than 300°C, greater than 350°C, greater than 370°C, greater than 380°C, greater than 390°C, between 300°C and 450°C, between 350°C and 450°C, between 380°C and 450°C, between 300°C and 500°C, or any suitable combination, sub-combination, range, or sub-range therein. In further embodiments, the decomposition temperature of the second fluid 117 and/or the third fluid 119 differ or are the same, being greater than 200°C, greater than 300°C, greater than 350°C, greater than 370°C, greater than 380°C, greater than 390°C, between 300°C and 450°C, between 350°C and 450°C, between 380°C and 450°C, between 300°C and 500°C, or any suitable combination, sub-combination, range, or sub-range therein.

In one embodiment, the coating 121 is produced with the partial pressures for the fluid(s) being between 1 Torr and 10 Torr, 1 Torr and 5 Torr, 1 Torr and 3 Torr, 2 Torr and 3 Torr, 10 Torr and 150 Torr, between 10 Torr and 30 Torr, between 20 Torr and 40 Torr, between 30 Torr and 50 Torr, between 60 Torr and 80 Torr, between 50 Torr and 100 Torr, between 50 Torr and 250 Torr, between 100 Torr and 250 Torr, between 200 Torr and 450 Torr, between 300 Torr and 450 Torr, between 300 Torr and 400 Torr, less than 400 Torr, less than 250 Torr, less than 100 Torr, less than 50 Torr, less than 30 Torr, or any suitable combination, sub-combination, range, or sub-range therein.

In one embodiment, the coating 121 is produced with the temperature and the pressure within the enclosed vessel 113 during one, more than one, or all cycles, being maintained for at least 10 minutes, at least 20 minutes, at least 30 minutes, at least 45 minutes, at least 1 hour, at least 2 hours, at least 3 hours, at least 4 hours, at least 5 hours, at least 7 hours, between 10 minutes and 1 hour, between 20 minutes and 45 minutes, between 4 and 10 hours, between 6 and 8 hours, or any suitable combination, sub-combination, range, or sub-range therein.

In one embodiment, the coating 121 and the substrate are devoid of thermal sensitization effects that occur at or above certain temperatures, such as, 405 degrees Celsius, 415 degrees Celsius, 425 degrees Celsius, 450 degrees Celsius, or any suitable combination, sub-combination, range, or sub-range therein. In a further embodiment, for the coating 121 such thermal sensitization effects include thermally-catalyzed crystallization of silicon.

Although the process 100 preferably is for aluminum-containing substrates, the process 100 is able to be used on any substrate 103 capable of being coated through the process 100. In various embodiments, the substrate 103 is a metallic material that is tempered or non-tempered, has grain structures that are equiaxed, directionally-solidified, and/or single crystal, has amorphous or crystalline structures, is a foil, fiber, a cladding, and/or a film. Suitable metallic materials include, but are not limited to, ferrous-based alloys, non-ferrous-based alloys, nickel-based alloys, stainless steels (martensitic or austenitic), aluminum-containing materials (for example, alloys, Alloy 6061, aluminum), composite metals, or combinations thereof. In an alternative embodiment, the metallic material is replaced with a non-metallic material. Suitable non-metal or non-metallic materials include, but are not limited to, ceramics, glass, ceramic matrix composites, or a combination thereof.

In one embodiment, the metallic material has a first iron concentration and a first chromium concentration, the first iron concentration being greater than the first chromium concentration. For example, suitable values for the first iron concentration include, but are not limited to, by weight, greater than 50%, greater than 60%, greater than 66%, greater than 70%, between 66% and 74%, between 70% and 74%, or any suitable combination, sub-combination, range, or sub-range therein. Suitable values for the first chromium concentration include, but are not limited to, by weight, greater than 10.5%, greater than 14%, greater than 16%, greater than 18%, greater than 20%, between 14% and 17%, between 16% and 18%, between 18% and 20%, between 20% and 24%, or any suitable combination, sub-combination, range, or sub-range therein.

In one embodiment, the metallic material is or includes a composition, by weight, of up to 0.08% carbon, between 18% and 20% chromium, up to 2% manganese, between 8% and 10.5% nickel, up to 0.045% phosphorus, up to 0.03% sulfur, up to 1% silicon, and a balance of iron (for example, between 66% and 74% iron).

In one embodiment, the metallic material is or includes a composition, by weight, of up to 0.08% carbon, up to 2% manganese, up to 0.045% phosphorus, up to 0.03% sulfur, up to 0.75% silicon, between 16% and 18% chromium, between 10% and 14% nickel, between 2% and 3% molybdenum, up to 0.1% nitrogen, and a balance of iron.

In one embodiment, the metallic material is or includes a composition, by weight, of up to 0.03% carbon, up to 2% manganese, up to 0.045% phosphorus, up to 0.03% sulfur, up to 0.75% silicon, between 16% and 18% chromium, between 10% and 14% nickel, between 2% and 3% molybdenum, up to 0.1% nitrogen, and a balance of iron.

In one embodiment, the metallic material is or includes a composition, by weight, of between 14% and 17% chromium, between 6% and 10% iron, between 0.5% and 1.5% manganese, between 0.1% and 1% copper, between 0.1% and 1% silicon, between 0.01% and 0.2% carbon, between 0.001% and 0.2% sulfur, and a balance nickel (for example, 72%).

In one embodiment, the metallic material is or includes a composition, by weight, of between 20% and 24% chromium, between 1% and 5% iron, between 8% and 10% molybdenum, between 10% and 15% cobalt, between 0.1% and 1% manganese, between 0.1% and 1% copper, between 0.8% and 1.5% aluminum, between 0.1% and 1% titanium, between 0.1% and 1% silicon, between 0.01% and 0.2% carbon, between 0.001% and 0.2% sulfur, between 0.001% and 0.2% phosphorus, between 0.001% and 0.2% boron, and a balance nickel (for example, between 44.2% and 56%).

In one embodiment, the metallic material is or includes a composition, by weight, of between 20% and 23% chromium, between 4% and 6% iron, between 8% and 10% molybdenum, between 3% and 4.5% niobium, between 0.5% and 1.5% cobalt, between 0.1% and 1% manganese, between 0.1% and 1% aluminum, between 0.1% and 1% titanium, between 0.1% and 1% silicon, between 0.01% and 0.5% carbon, between 0.001% and 0.02% sulfur, between 0.001% and 0.02% phosphorus, and a balance nickel (for example, 58%).

In one embodiment, the metallic material is or includes a composition, by weight, of between 25% and 35% chromium, between 8% and 10% iron, between 0.2% and 0.5% manganese, between 0.005% and 0.02% copper, between 0.01% and 0.03% aluminum, between 0.3% and 0.4% silicon, between 0.005% and 0.03% carbon, between 0.001% and 0.005% sulfur, and a balance nickel (for example, 59.5%).

In one embodiment, the metallic material is or includes a composition, by weight, of between 17% and 21% chromium, between 2.8% and 3.3% iron, between 4.75% and 5.5% niobium, between 0.5% and 1.5% cobalt, between 0.1% and 0.5% manganese, between 0.2% and 0.8% copper, between 0.65% and 1.15% aluminum, between 0.2% and 0.4% titanium, between 0.3% and 0.4% silicon, between 0.01% and 1% carbon, between 0.001 and 0.02% sulfur, between 0.001 and 0.02% phosphorus, between 0.001 and 0.02% boron, and a balance nickel (for example, between 50% and 55%).

In one embodiment, the metallic material is or includes a composition, by weight, of between 2% and 3% cobalt, between 15% and 17% chromium, between 5% and 17% molybdenum, between 3% and 5% tungsten, between 4% and 6% iron, between 0.5% and 1% silicon, between 0.5% and 1.5% manganese, between 0.005 and 0.02% carbon, between 0.3% and 0.4% vanadium, and a balance nickel.

In one embodiment, the metallic material is or includes a composition, by weight, of up to 0.15% carbon, between 3.5% and 5.5% tungsten, between 4.5% and 7% iron, between 15.5% and 17.5% chromium, between 16% and 18% molybdenum, between 0.2% and 0.4% vanadium, up to 1% manganese, up to 1% sulfur, up to 1% silicon, up to 0.04% phosphorus, up to 0.03% sulfur, and a balance nickel.

In one embodiment, the metallic material is or includes a composition, by weight, of up to 2.5% cobalt, up to 22% chromium, up to 13% molybdenum, up to 3% tungsten, up to 3% iron, up to 0.08% silicon, up to 0.5% manganese, up to 0.01% carbon, up to 0.35% vanadium, and a balance nickel (for example, 56%).

In one embodiment, the metallic material is or includes a composition, by weight, of between 1% and 2% cobalt, between 20% and 22% chromium, between 8% and 10% molybdenum, between 0.1% and 1% tungsten, between 17% and 20% iron, between 0.1% and 1% silicon, between 0.1% and 1% manganese, between 0.05 and 0.2% carbon, and a balance nickel.

In one embodiment, the metallic material is or includes a composition, by weight, of between 0.01% and 0.05% boron, between 0.01% and 0.1% chromium, between 0.003% and 0.35% copper, between 0.005% and 0.03% gallium, between 0.006% and 0.8% iron, between 0.006% and 0.3% magnesium, between 0.02% and 1% silicon + iron, between 0.006% and 0.35% silicon, between 0.002% and 0.2% titanium, between 0.01% and 0.03% vanadium + titanium, between 0.005% and 0.05% vanadium, between 0.006% and 0.1% zinc, and a balance aluminum (for example, greater than 99%)

In one embodiment, the metallic material is or includes a composition, by weight, of between 0.05% and 0.4% chromium, between 0.03% and 0.9% copper, between 0.05% and 1% iron, between 0.05% and 1.5% magnesium, between 0.5% and 1.8% manganese, between 0.5% and 0.1% nickel, between 0.03% and 0.35% titanium, up to 0.5% vanadium, between 0.04% and 1.3% zinc, and a balance aluminum (for example, between 94.3% and 99.8%).

In one embodiment, the metallic material is or includes a composition, by weight, of between 0.0003% and 0.07% beryllium, between 0.02% and 2% bismuth, between 0.01% and 0.25% chromium, between 0.03% and 5% copper, between 0.09% and 5.4% iron, between 0.01% and 2% magnesium, between 0.03% and 1.5% manganese, between 0.15% and 2.2% nickel, between 0.6% and 21.5% silicon, between 0.005% and 0.2% titanium, between 0.05% and 10.7% zinc, and a balance aluminum (for example, between 70.7% to 98.7%).

In one embodiment, the metallic material is or includes a composition, by weight, of between 0.15% and 1.5% bismuth, between 0.003% and 0.06% boron, between 0.03% and 0.4% chromium, between 0.01% and 1.2% copper, between 0.12% and 0.5% chromium + manganese, between 0.04% and 1% iron, between 0.003% and 2% lead, between 0.2% and 3% magnesium, between 0.02% and 1.4% manganese, between 0.05% and 0.2% nickel, between 0.5% and 0.5% oxygen, between 0.2% and 1.8% silicon, up to 0.05% strontium, between 0.05% and 2% tin, between 0.01% and 0.25% titanium, between 0.05% and 0.3% vanadium, between 0.03% and 2.4% zinc, between 0.05% and 0.2% zirconium, between 0.150 and 0.2% zirconium + titanium, and a balance of aluminum (for example, between 91.7% and 99.6%).

In one embodiment, the metallic material is or includes a composition, by weight, of between 0.4% and 0.8% silicon, up to 0.7% iron, between 0.15% and 0.4% copper, up to 0.15% manganese, between 0.8% and 1.2% magnesium, between 0.04% and 0.35% chromium, up to 0.25% zinc, up to 0.15% titanium, optional incidental impurities (for example, at less than 0.05% each, totaling less than 0.15%), and a balance of aluminum (for example, between 95% and 98.6%).

In one embodiment, the metallic material is or includes a composition, by weight, of between 11% and 13% silicon, up to 0.6% impurities/residuals, and a balance of aluminum.

In one embodiment, the metallic material is or includes a composition, by weight, of between 0.7% and 1.1% magnesium, between 0.6% and 0.9% silicon, between 0.2% and 0.7% iron, between 0.1% and 0.4% copper, between 0.05% and 0.2% manganese, 0.02% and 0.1% zinc, 0.02% and 0.1% titanium, and a balance aluminum. In a further embodiment, the metallic material is Alloy 6061.

In one embodiment, the coated article 101 has a use/application previously considered incompatible thermal chemical vapor deposition. For example, in one embodiment, the substrate 103 is aluminum-containing substrate and the coated article 103 is used in the oil and gas industries. In further embodiments, suitable uses of the coated article 101 include, but are not limited to, as pumps, portions of pumps (such as, pump vanes), tubular and/or piping elements, off-shore oil and gas systems (with or without exposure to saltwater), well pads, drilling components, compressive natural gas extraction, upstream and/or downstream flow paths, petrochemical refineries, hydrocarbon processing, process analyzers, dissolved gas analyzers, galvanic corrosive environments, mercuric corrosive environments, and/or other suitable uses within the oil and gas. Such embodiments include exposing the coated article 101 to conditions, such as, specific gases, specific liquids, specific temperatures, specific pressures, specific forces, and/or other specific conditions applicable within such industries.

In one embodiment, the substrate 103 is the aluminum-containing substrate and the coated article 103 is used in the analytical instrumentation industries. In further embodiments, suitable uses of the coated article 101 include, but are not limited to, as the gas storage vessels, the fittings, the compression fittings, the tubing, the valves, the quick-connects, the sample cylinders, the regulators and/or the flow-controllers, the injection ports, the in-line filters, the frits, the columns, the materials, the glass liners, the gas chromatograph components, the liquid chromatography components, the components associated with the vacuum systems and the chambers, the components associated with the analytical systems, the sample probes, the control probes, the particles, the powders, or a combination thereof. Such embodiments include exposing the coated article 101 to conditions, such as, specific gases, specific liquids, specific temperatures, specific pressures, specific forces, and/or other specific conditions applicable within such industries.

In one embodiment, the substrate 103 is the aluminum-containing substrate and the coated article 103 is used in the transportation and logistics industries. In further embodiments, suitable uses of the coated article 101 include, but are not limited to, as rails, racks, drive-trains, rods, clamps, bolts, guiderails, wheel wells, lattices, filters, liquid or gas storage containers (for example, in the beverage industry and/or in the chemical storage and transport industry), loading platforms, and/or other suitable uses within the transportation and logistics industries. Such embodiments include exposing the coated article 101 to conditions, such as, specific gases, specific liquids, specific temperatures, specific pressures, specific forces, and/or other specific conditions applicable within such industries.

In one embodiment, the substrate 103 is the aluminum-containing substrate and the coated article 103 is used in the facilities management industries. In further embodiments, suitable uses of the coated article 101 include, but are not limited to, as heating systems and components, ventilation systems and components, chillers, heat exchangers, water heaters, and/or other suitable uses within the facilities management industries. Such embodiments include exposing the coated article 101 to conditions, such as, specific gases, specific liquids, specific temperatures, specific pressures, specific forces, and/or other specific conditions applicable within such industries.

In one embodiment, the substrate 103 is the aluminum-containing substrate and the coated article 103 is used in the food and beverage industries. In further embodiments, suitable uses of the coated article 101 include, but are not limited to, as distillery components, fermentation components, nozzles, taps, and/or other suitable uses within the food and beverage industries. Such embodiments include exposing the coated article 101 to conditions, such as, specific gases, specific liquids, specific temperatures, specific pressures, specific forces, and/or other specific conditions applicable within such industries.

In one embodiment, the substrate 103 is the aluminum-containing substrate and the coated article 103 is used in the aviation, defense, and/or aerospace industries. In further embodiments, suitable uses of the coated article 101 include, but are not limited to, as blades, vanes, rotors, stators, injectors, nozzles, turbulators, wings, fins, fuselage, rivets, landing gear, and/or other suitable uses within the aviation, defense, and/or aerospace industries. Such embodiments include exposing the coated article 101 to conditions, such as, specific gases, specific liquids, specific temperatures, specific pressures, specific forces, and/or other specific conditions applicable within such industries.

In one embodiment, the substrate 103 is the aluminum-containing substrate and the coated article 103 is used in the automotive industries. In further embodiments, suitable uses of the coated article 101 include, but are not limited to, as pistons, injectors, rings, fuel lines, fluid pathways, fluid storage components, and/or other suitable uses within the automotive industries. Such embodiments include exposing the coated article 101 to conditions, such as, specific gases, specific liquids, specific temperatures, specific pressures, specific forces, and/or other specific conditions applicable within such industries.

In one embodiment, the substrate 103 is the aluminum-containing substrate and the coated article 103 is used in the medical and pharmaceutical industries. In further embodiments, suitable uses of the coated article 101 include, but are not limited to, as needles, catheters, stents, and/or other suitable uses within the medical and/or pharmaceutical industries. Such embodiments include exposing the coated article 101 to conditions, such as, specific gases, specific liquids, specific temperatures, specific pressures, specific forces, and/or other specific conditions applicable within such industries.

### EXAMPLES

In a first comparative example, Alloy 6061 is coated with a plurality of layers of amorphous silicon in a manner consistent with the process disclosed in United States Patent No. 6,511,760, entitled "METHOD OF PASSIVATING A GAS VESSEL OR COMPONENT OF A GAS TRANSFER SYSTEM USING A SILICON OVERLAY COATING." Table 1 comparatively shows the coated 304 stainless steel coated in the same manner, 316 stainless steel coated in the same manner, and uncoated samples of Alloy 6061, 304 stainless steel, and 316 stainless steel.

**TABLE 1**

| **Substrate** | **Corrosion Rate** (mils per year) |
|---|---|
| Uncoated Alloy 6061 | 931.6 in 5% HCl (by weight) |
| Uncoated 304 Stainless Steel | 200.5 in 5% HCl (by weight) |
| Uncoated 316 Stainless Steel | 34 in 5% HCl (by weight) |
| Multilayer amorphous silicon on Alloy 6061 | Not Available |
| Multilayer amorphous silicon on 304 Stainless Steel | 0.37 in 5% HCl (by weight) |
| Multilayer amorphous silicon on 316 Stainless Steel | 0.018 in 5% HCl (by weight) |

In addition to the corrosion rates identified in Table 1, with regard to the first comparative example, the deposition of multiple layers of amorphous silicon on Alloy 6061 results in the coating being crystalline in nature, independent of whether pressures are at one level or half of the same level, whether the duration of the process is at one duration or half that of the same duration, whether the substrate is thermally oxidized or not, or whether the temperatures are decreased to the lowest temperatures allowing decomposition of the silane without an external energy source, such as, plasma. Such crystallinity is capable of detection through visual inspection or use of Raman spectroscopy.

Weight change consistent with ASTM G85-A2, a 5% NaCl Salt Spray test, for the uncoated Alloy 6061 is between 25 mg and 30 mg over a period of 4 weeks.

In a second comparative example, Alloy 6061 is coated with amorphous silicon then functionalized in a manner consistent with the process disclosed in United States Patent No. 6,444,326, entitled "SURFACE MODIFICATION OF SOLID SUPPORTS THROUGH THE THERMAL DECONIPOSITION AND FUNCTIONALIZATION OF SILANES." Table 2 shows the corrosion rates associated with the second comparative example as well as 304 stainless steel and 316 stainless steel coated using the same process:

**TABLE 2**

| | |
|---|---|
| Substrate Coated Per Example 2 | Corrosion Rate (mils per year) |
| Alloy 6061 | 254.4 in 5% HCl (by weight) |
| 304 Stainless Steel | 0.44 in 5% HCl (by weight) |
| 316 Stainless Steel | 0.30 in 5% HCl (by weight) |

Weight change consistent with ASTM G85-A2, a 5% NaCl Salt Spray test, for the coated Alloy 6061 according to comparative example 2 is between 3 mg and 9 mg over a period of 4 weeks.

In a third comparative example, Alloy 6061 is coated by decomposition of dimethylsilane then functionalized with trimethylsilane in a manner consistent with the process disclosed in United States Patent No. 9,777,368, entitled "CHEMICAL VAPOR DEPOSITION COATING, ARTICLE, AND METHOD." Table 3 shows the corrosion rates associated with the third comparative example as well as 304 stainless steel and 316 stainless steel coated using the same process:

**TABLE 3**

| | |
|---|---|
| Substrate Coated Per Example 3 | Corrosion Rate (mils per year) |
| Alloy 6061 | 916.5 in 5% HCl (by weight) |
| 304 Stainless Steel | 0.24 in 5% HCl (by weight) |
| 316 Stainless Steel | 0.248 in 5% HCl (by weight) |

The coated Alloy 6061 produced by decomposition of dimethylsilane at 450 degrees Celsius, followed by oxidation and two cycles of silane decomposition, is amorphous, but the Alloy 6061 substrate shows thermal sensitization.

In a series of additional examples shown in Table 4, according to embodiments of the present disclosure, Alloy 6061 is coated by decomposition dimethylsilane in the presence of silane at 405 degrees Celsius, followed by oxidation and two cycles of silane. The dimethylsilane in the presence of the silane is at a ratio identified in Table 4, resulting in thicknesses shown in Table 4. At certain ratios shown in Table 4, silicon (for example, corresponding with the amorphous-silicon-containing layer 107 and/or the additional layer 109) of the coating 121 is crystalline, but the Alloy 6061 substrate does not show thermal sensitization. At other ratios shown in Table 4, the silicon (for example, corresponding with the amorphous-silicon-containing layer 107 and/or the additional layer 109) of the coating 121 is amorphous, and the Alloy 6061 substrate does not show thermal sensitization.

**TABLE 4**

| Dimethylsilane to Silane Ratio | Partial Pressure of Dimethylsilane | Coating Microstructure on 304 Stainless Steel | Coating Microstructure on Alloy 6061 |
|---|---|---|---|
| 0 to 1 | N/A | Amorphous (154 nm) | Crystalline (210 or 220 nm) |
| 1 to 5.33 | 30 Torr | Amorphous (155 nm) | Inconsistent (192 or 324 nm) |
| 1 to 1.93 | 100 Torr | Amorphous (215 nm) | Crystalline (397 or 490 nm) |
| 1 to 1.13 | 650 Torr | Amorphous (656 nm) | Crystalline (668 or 864 nm) |
| 1.09 to 1 | 1,000 Torr | Amorphous (94 nm) | Crystalline (68 nm or 73 nm) |
| 6.61 to 1 | 650 Torr | Amorphous (178 nm) | Crystalline (200 nm) |
| 1 to 0 | 400 Torr | Amorphous (176 nm) | Crystalline (209 or 252 nm) |
| 1.71 to 1 | 100 Torr | Amorphous (261 nm) | Amorphous (381 or 447 nm) |
| 2.52 to 1 | 200 Torr | Amorphous (241 nm) | Amorphous (406 or 468 nm) |
| 4.14 to 1 | 300 Torr | Amorphous (286 nm) | Amorphous (332 or 419 nm) |
| 4.58 to 1 | 350 Torr | Amorphous (200 nm) | Amorphous (216 or 290 nm) |
| 5.77 to 1 | 400 Torr | Amorphous (200 nm) | Crystalline (216 or 290 nm) |

The coated Alloy 6061 coated according to a ratio of 3.09:1 (200 Torr dimethylsilane) shows corrosion of 1.39 mils per year in 2.5% (by weight) HCl after 20 minutes of immersion. The coated Alloy 6061 coated according to a ratio of dimethylsilane to silane between 2:1 and 4:1 shows corrosion of between 10-20 mils per year in 5% (by weight) HCl after 20 minutes of immersion. Weight change consistent with ASTM G85-A2, a 5% NaCl Salt Spray test, for the coated Alloy 6061 coated according to similar conditions (ratio of dimethylsilane to silane of between 2:1 and 4:1) is less than 1 mg over a period of 4 weeks.

While the invention has been described with reference to one or more embodiments, it will be understood by those skilled in the art that various changes may be made without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims. In addition, all numerical values identified in the detailed description shall be interpreted as though the precise and approximate values are both expressly identified. Likewise, compositions disclosed are to be interpreted as thought impurities and/or residuals may be present, as would be appreciated by those skilled in the art.

## Claims

1. A coated article (121), comprising:
an aluminum-containing substrate (103);
a first layer (105) on the aluminum-containing substrate (103), the first layer (105) comprising carbon and silicon, the first layer (105) being in contact with the substrate (103);
a second layer (107) distal in a thickness direction from the aluminum-containing substrate (103) in comparison to the first layer (105), the second layer (107) having oxygen at a greater concentration, by weight, than the first layer (105), the second layer (107) being in contact with the first layer (105);
a third layer (109) distal in a thickness direction from the first layer (105) in comparison to the second layer (107), the third layer (109) comprising amorphous silicon, the third layer (109) being in contact with the second layer (107).

2. The coated article (121) of claim 1, wherein the first layer (105) is a thermal chemical vapor deposition of a dimethylsilane-and-silane-containing mixture.

3. A fluid contact process, comprising:
flowing a corrosive fluid to contact a coated article (121), the coated article having an aluminum-containing substrate (103), a first layer (105) on the aluminum-containing substrate (103), the first layer (105) comprising carbon and silicon, the first layer (105) being in contact with the substrate (103); a second layer(107) distal in a thickness direction from the aluminum-containing substrate (103) in comparison to the first layer (105), the second layer (107) having oxygen at a greater concentration, by weight, than the first layer (105), the second layer (107) being in contact with the first layer (105); and a third layer (109) distal in a thickness direction from the first layer (105) in comparison to the second layer (107), the third layer (109)comprising amorphous silicon, the third layer (109) being in contact with the second layer (107).

4. A coated article (121) according to claim 1 or 2, wherein the coated article is used in analytical instrumentation industries.

5. A coated article (121) according to claim 1 or 2, wherein the coated article is used in oil and gas industries.

6. A coated article (121) according to claim 1 or 2, wherein the coated article is used in transportation and logistics.

7. A coated article (121) according to claim lor 2, wherein the coated article is used in facilities management.

8. A coated article (121) according to claim 1 or 2, wherein the coated article is used in food and beverage industries.

9. A coated article (121) according to claim 1 or 2, wherein the coated article is used in aviation, defense, or aerospace industries.

10. A coated article (121) according to claim 1 or 2, wherein the coated article is used in automotive industries.

11. A coated article (121) according to claim 1 or 2, wherein the coated article is used in medical or pharmaceutical industries.

12. A coating process, comprising:
positioning an aluminum-containing substrate (103) within an enclosed chamber (113); then,
thermally decomposing a dimethylsilane-and-silane-containing mixture within the enclosed chamber (113)thereby applying carbon and silicon to all surfaces exposed to the dimethylsilane-and-silane-containing mixture within the enclosed chamber (113) to produce a first layer (105), the first layer (105) being in contact with the substrate (103); then,
thermally oxidizing the first layer (105) thereby producing a second layer (107) distal in a thickness direction from the aluminum-containing substrate (103) in comparison to the first layer (105), the second layer (107) having oxygen at a greater concentration, by weight, than the first layer (105), the second layer (107) being in contact with the first layer (105); and then,
thermally decomposing silane within the enclosed chamber (113) thereby producing a third layer (109) distal in a thickness direction from the first layer (105) in comparison to the second layer (107), the third layer (109) comprising amorphous silicon, the third layer (109) being in contact with the second layer (107).

## Patentansprüche

1. Beschichteter Gegenstand (121), umfassend:
ein aluminiumhaltiges Substrat (103);
eine erste Schicht (105) auf dem aluminiumhaltigen Substrat (103), wobei die erste Schicht (105) Kohlenstoff und Silicium umfasst, wobei die erste Schicht (105) in Kontakt mit dem Substrat (103) steht;
eine zweite Schicht (107), die in einer Dickenrichtung von dem aluminiumhaltigen Substrat (103) im Vergleich zu der ersten Schicht (105) beabstandet ist, wobei die zweite Schicht (107) Sauerstoff in einer größeren Konzentration, bezogen auf das Gewicht, als die erste Schicht (105) aufweist, wobei die zweite Schicht (107) in Kontakt mit der ersten Schicht (105) steht;
eine dritte Schicht (109), die in einer Dickenrichtung von der ersten Schicht (105) im Vergleich zu der zweiten Schicht (107) beabstandet ist, wobei die dritte Schicht (109) amorphes Silicium umfasst, wobei die dritte Schicht (109) in Kontakt mit der zweiten Schicht (107) steht.

2. Beschichteter Gegenstand (121) nach Anspruch 1, wobei die erste Schicht (105) eine thermisch-chemische Gasphasenabscheidung eines Dimethylsilan und Silan enthaltenden Gemisches ist.

3. Fluidkontaktverfahren, umfassend:
Strömenlassen eines korrosiven Fluids, um einen beschichteten Gegenstand (121) zu kontaktieren, wobei der beschichtete Gegenstand ein aluminiumhaltiges Substrat (103); eine erste Schicht (105) auf dem aluminiumhaltigen Substrat (103), wobei die erste Schicht (105) Kohlenstoff und Silicium umfasst, wobei die erste Schicht (105) in Kontakt mit dem Substrat (103) steht; eine zweite Schicht (107), die in einer Dickenrichtung von dem aluminiumhaltigen Substrat (103) im Vergleich zu der ersten Schicht (105) beabstandet ist, wobei die zweite Schicht (107) Sauerstoff in einer größeren Konzentration, bezogen auf das Gewicht, als die erste Schicht (105) aufweist, wobei die zweite Schicht (107) in Kontakt mit der ersten Schicht (105) steht; und eine dritte Schicht (109), die in einer Dickenrichtung von der ersten Schicht (105) im Vergleich zu der zweiten Schicht (107) beabstandet ist, wobei die dritte Schicht (109) amorphes Silicium umfasst, wobei die dritte Schicht (109) in Kontakt mit der zweiten Schicht (107) steht; aufweist.

4. Beschichteter Gegenstand (121) nach Anspruch 1 oder 2, wobei der beschichtete Gegenstand auf dem industriellen Gebiet analytischer Instrumente verwendet wird.

5. Beschichteter Gegenstand (121) nach Anspruch 1 oder 2, wobei der beschichtete Gegenstand in der Öl- und Gasindustrie verwendet wird.

6. Beschichteter Gegenstand (121) nach Anspruch 1 oder 2, wobei der beschichtete Gegenstand in der Transport- und Logistikbranche verwendet wird.

7. Beschichteter Gegenstand (121) nach Anspruch 1 oder 2, wobei der beschichtete Gegenstand im Gebäudemanagement verwendet wird.

8. Beschichteter Gegenstand (121) nach Anspruch 1 oder 2, wobei der beschichtete Gegenstand in der Lebensmittel- und Getränkeindustrie verwendet wird.

9. Beschichteter Gegenstand (121) nach Anspruch 1 oder 2, wobei der beschichtete Gegenstand in der Luft-, Verteidigungs- oder Raumfahrtindustrie verwendet wird.

10. Beschichteter Gegenstand (121) nach Anspruch 1 oder 2, wobei der beschichtete Gegenstand in der Automobilbranche verwendet wird.

11. Beschichteter Gegenstand (121) nach Anspruch 1 oder 2, wobei der beschichtete Gegenstand in der medizinischen oder pharmazeutischen Industrie verwendet wird.

12. Beschichtungsverfahren umfassend:
Positionieren eines aluminiumhaltigen Substrats (103) innerhalb einer geschlossenen Kammer (113); dann,
thermisches Zersetzen eines Dimethylsilan und Silan enthaltenden Gemisches innerhalb der geschlossenen Kammer (113), wodurch Kohlenstoff und Silicium auf alle Oberflächen aufgebracht werden, die dem Dimethylsilan und Silan enthaltenden Gemisch innerhalb der geschlossenen Kammer (113) ausgesetzt sind, um eine erste Schicht (105) zu erzeugen, wobei die erste Schicht (105) in Kontakt mit dem Substrat (103) steht; dann,
thermisches Oxidieren der ersten Schicht (105), wodurch eine zweite Schicht (107) erzeugt wird, die in einer Dickenrichtung von dem aluminiumhaltigen Substrat (103) im Vergleich zu der ersten Schicht (105) beabstandet ist, wobei die zweite Schicht (107) Sauerstoff in einer größeren Konzentration, bezogen auf das Gewicht, als die erste Schicht (105) aufweist, wobei die zweite Schicht (107) in Kontakt mit der ersten Schicht (105) steht; und dann,
thermisches Zersetzen von Silan innerhalb der geschlossenen Kammer (113), wodurch eine dritte Schicht (109) erzeugt wird, die in einer Dickenrichtung von der ersten Schicht (105) im Vergleich zu der zweiten Schicht (107) beabstandet ist, wobei die dritte Schicht (109) amorphes Silicium umfasst, wobei die dritte Schicht (109) in Kontakt mit der zweiten Schicht (107) steht.

## Revendications

1. Un article revêtu (121), comprenant :
un substrat contenant de l'aluminium (103) ;
une première couche (105) sur le substrat contenant de l'aluminium (103), la première couche (105) comprenant du carbone et du silicium, la première couche (105) étant en contact avec le substrat (103) ;
une deuxième couche distale (107) dans le sens de l'épaisseur du substrat contenant de l'aluminium (103) par rapport à la première couche (105), la deuxième couche (107) contenant de l'oxygène à une concentration supérieure, en poids, à celle de la première couche (105), la deuxième couche (107) étant en contact avec la première couche (105) ;
une troisième couche distale (109) dans le sens de l'épaisseur de la première couche (105) par rapport à la deuxième couche (107), la troisième couche (109) comprenant du silicium amorphe, la troisième couche (109) étant en contact avec la deuxième couche (107).

2. L'article revêtu (121) selon la revendication 1, dans lequel la première couche (105) est un dépôt chimique thermique en phase vapeur d'un mélange contenant du diméthylsilane et du silane.

3. Un procédé de contact fluidique, comprenant les étapes consistant à :
faire circuler un fluide corrosif pour entrer en contact avec un article revêtu (121), l'article revêtu ayant un substrat contenant de l'aluminium (103), une première couche (105) sur le substrat contenant de l'aluminium (103), la première couche (105) comprenant du carbone et du silicium, la première couche (105) étant en contact avec le substrat (103) ; une deuxième couche distale (107) dans le sens de l'épaisseur du substrat contenant de l'aluminium (103) par rapport à la première couche (105), la deuxième couche (107) contenant de l'oxygène à une concentration en poids supérieure à celle de la première couche (105), la deuxième couche (107) étant en contact avec la première couche (105) ; et une troisième couche distale (109) dans le sens de l'épaisseur de la première couche (105) par rapport à la deuxième couche (107), la troisième couche (109) comprenant du silicium amorphe, la troisième couche (109) étant en contact avec la deuxième couche (107).

4. Un article revêtu (121) selon la revendication 1 ou 2, dans lequel l'article revêtu est utilisé dans les industries d'instrumentation analytique.

5. Un article revêtu (121) selon la revendication 1 ou 2, dans lequel l'article revêtu est utilisé dans les industries pétrolières et gazières.

6. Un article revêtu (121) selon la revendication 1 ou 2, dans lequel l'article revêtu est utilisé dans le transport et la logistique.

7. Un article revêtu (121) selon la revendication 1 ou 2, dans lequel l'article revêtu est utilisé dans la gestion d'installations.

8. Un article revêtu (121) selon la revendication 1 ou 2, dans lequel l'article revêtu est utilisé dans les industries alimentaires et des boissons.

9. Un article revêtu (121) selon la revendication 1 ou 2, dans lequel l'article revêtu est utilisé dans les industries de l'aviation, de la défense ou de l'aérospatiale.

10. Un article revêtu (121) selon la revendication 1 ou 2, dans lequel l'article revêtu est utilisé dans les industries automobiles.

11. Un article revêtu (121) selon la revendication 1 ou 2, lequel article revêtu est utilisé dans les industries médicales ou pharmaceutiques.

12. Un procédé de revêtement, comprenant :
le positionnement d'un substrat contenant de l'aluminium (103) à l'intérieur d'une chambre fermée (113); puis,
la décomposition thermique d'un mélange contenant du diméthylsilane et du silane à l'intérieur de la chambre fermée (113), appliquant ainsi du carbone et du silicium à toutes les surfaces exposées au mélange contenant du diméthylsilane et du silane à l'intérieur de la chambre fermée (113) pour produire une première couche (105), la première couche (105) étant en contact avec le substrat (103) ; puis,
l'oxydation thermique de la première couche (105), produisant ainsi une deuxième couche distale (107) dans le sens de l'épaisseur du substrat contenant de l'aluminium (103) par comparaison avec la première couche (105), la deuxième couche (107) contenant de l'oxygène à une concentration, en poids, supérieure à celle de la première couche (105), la deuxième couche (107) étant en contact avec la première couche (105) ; puis
la décomposition thermique du silane à l'intérieur de la chambre fermée (113), produisant ainsi une troisième couche distale (109) dans le sens de l'épaisseur de la première couche (105) par comparaison avec la deuxième couche (107), la troisième couche (109) comprenant du silicium amorphe, la troisième couche (109) étant en contact avec la deuxième couche (107).
